# EUROPEAN PATENT SPECIFICATION

(11) **EP 2 960 718 B1**
(45) Date of publication and mention of the grant of the patent: **21.04.2021**
(21) Application number: 15172055.4
(22) Date of filing: 15.06.2015
(51) Int. Cl.: G03F 7/00, B29C 67/00, G03F 7/027

(54) **MODELING MATERIAL FOR FORMING PHOTOFABRICATION MODEL IN INK-JET STEREO LITHOGRAPHY AND PRODUCTION METHOD OF PHOTOFABRICATION MODEL**
MODELLIERUNGSMATERIAL ZUR HERSTELLUNG EINES FOTOFABRIKATIONSMODELLS IN DER STEREO-LITHOGRAPHIE UND VERFAHREN ZUR HERSTELLUNG EINES FOTOFABRIKATIONSMODELLS
MATÉRIAU DE MODELAGE DE FORMATION DE MODÈLE DE PHOTOFABRICATION DANS LA STÉRÉO LITHOGRAPHIE À JET D'ENCRE ET PROCÉDÉ DE PRODUCTION D'UN TEL MODÈLE

(30) Priority: 20.06.2014 JP 2014126814; 02.04.2015 JP 2015076069
(43) Date of publication of application: 30.12.2015
(73) Proprietor: Keyence Corporation, Osaka-shi, Osaka 533-8555 (JP); Sanyo Chemical Industries, Ltd., Kyoto-shi, Kyoto 605-0995 (JP)
(72) Inventor: Ikeda, Shigeki, Osaka, 533-8555 (JP); Yoshida, Kazunori, Kyoto, 605-0995 (JP)
(74) Representative: Hoffmann Eitle

(56) References cited:
- EP-A1- 2 636 511

## Description

### 1. Field of the Invention

The present invention relates to a modeling material for forming a photofabrication model in ink-jet stereo lithography, a two-pack photocurable composition for ink-jet stereo lithography, a photofabrication model obtained by allowing the composition to be photocured, and a production method of a photofabrication model using the composition.

### 2. Description of Related Art

A method of irradiating a liquid photocurable resin with light such as a laser beam or ultraviolet rays to cure the resin in a given pattern and preparing a design model or a working model in three dimensions has been widely known, and various resins have been proposed as the liquid photocurable resin (see, for example, JP-A-1-204915, JP-A-8-59760, JP-A-9-169827, JP-A-9-316111, JP-A-2001-310918 and JP-A-2004-59601).

In recent years, the stereo lithography employing an ink-jet method has been proposed, and compared with the conventional method, it has been made possible to cure the liquid photocurable resin discharged from an ink jet nozzle and to stack layers and carry out the photofabrication. The stereo lithography has advantages that, for example, a large tank for the liquid resin and provision of a dark room used in the conventional method are not necessary. It is made possible to allow a photofabrication apparatus to be compact and become smaller, and by employing a CAD (Computer Aided Design) system, the apparatus has been attracting attention as a 3-D CAD system capable of freely preparing a stereo model (see, for example, JP-A-2002-67174).

Moreover, not limited to the stereo lithography employing an ink-jet method, a method of carrying out the photofabrication using a modeling material for forming a photofabrication model and a supporting material supporting the shape of the photofabrication model on photofabrication has also been known in order to fabricate a photofabrication model having a complex shape (see, for example, JP-A-2002-178412 and JP-A-2004-255839).

Furthermore, in the photofabrication employing an ink-jet method, a method of preparing a photofabrication model using a specific modeling material and a specific supporting material has also been proposed (see, for example, EP-B-1 274 551, EP-A-1 741 545 and JP-A-2010-155926).

However, in a method of irradiating a resin with e.g. a laser beam or ultraviolet rays to carry out the photofabrication, although the resin is generally irradiated with e.g. a laser beam or ultraviolet rays from the upper side or lower side of the liquid level of a liquid photocurable resin while moving the liquid level up and down to prepare a photofabrication model, in general, such an apparatus has not been widely prevailing and the number of apparatus installed has been restrictive because there are problems that it is necessary to provide a dedicated dark room since the liquid photocurable resin is cured also with e.g. light from outside, only a portion of the liquid photocurable resin is used for the preparation of the photofabrication model, and further, the cost of equipment becomes very expensive since various incidental facilities are required for the photofabrication.

Moreover, with regard to the ink-jet method, although the above-mentioned problems can be alleviated, there is still a problem in the case of preparing a photofabrication model with a complex shape. That is, in the ink-jet method, it is necessary to combinedly use a modeling material and a supporting material and, for example, in the methods disclosed in EP-B-1 274 551, EP-A-1 741 545 and JP-A-2010-155926, the viscosity, surface tension and physical properties of a modeling material or a supporting material are taken into consideration, but there is a problem that a photofabrication model prepared by allowing the modeling material to be cured is low in heat resistance and is easily deformed by heat.

Separately, in general, as a method of elevating the heat resistance, a method of enhancing the degree of crosslinking of a modeling material is employed, but there is a problem of occurrence of a trouble in which the curing shrinkage is generated and the degree of warpage becomes very large.

EP-A-2 636 511 discloses a modeling material for forming a photofabrication model in ink-jet three dimensional printing method, comprising a curable resin component with a weighted average of SP value of 9.0 to 10.3. Preferably, the curable resin component contains a monofunctional ethylenically unsaturated monomer (A), a polyfunctional ethylenically unsaturated monomer containing no urethane group (B), a urethane group-containing polyfunctional ethylenically unsaturated monomer (C) and a photopolymerization initiator (D).

### SUMMARY OF THE INVENTION

The present invention has been made in view of the above-mentioned problems, and an object of the present invention is to suppress the warpage of a fabrication product by suppressing the curing shrinkage as much as possible, and to provide a modeling material for forming a photofabrication model excellent in heat resistance and mechanical properties and a production method of a photofabrication model excellent in productivity.

As a result of extensive researches for solving the above-mentioned problems, the present inventors have reached the present invention. That is, the present invention is directed to a modeling material for forming a photofabrication model in ink-jet stereo lithography (the present modeling material), comprising
(i) a monofunctional ethylenically unsaturated monomer (A) free from a urethane group, a homopolymer of which has a glass transition temperature of ≥ 80°C;
(ii) a polyfunctional ethylenically unsaturated monomer (B) free from a urethane group, a homopolymer of which has a glass transition temperature of ≥ 200°C;
(iii) an ethylenically unsaturated monomer (C) which is a polyfunctional ethylenically unsaturated monomer (C 1) having a urethane group in a concentration of 2.7-5.0 mmol/g; and
(iv) a photopolymerization initiator (D).

Also, the present invention is directed to a two-pack type photocurable composition suitable for ink-jet stereo lithography (the present composition) comprising a combination of
- a modelling material which is suitable for forming a photofabrication model in ink-jet stereo lithography and comprises the present modelling material, and
- a supporting material supporting the shape of the photofabrication model on photofabrication.

Yet further, the present invention is directed to a method of producing a photofabrication model (the present method), comprising the step of photocuring the present composition by ink-jet stereo lithography, and to a photofabrication model obtainable by this method.

Preferred embodiments of the invention are as defined in the appended dependent claims and/or in the following detailed description.

The photofabrication model prepared with the present modeling material is excellent in heat resistance and mechanical properties, and the present method is excellent in productivity.

### BRIEF DESCRIPTION OF THE DRAWINGS

Fig. 1 is a schematic view of a three-dimensional modeling system employing an ink-jet method;
Fig. 2 is a schematic side view showing a configuration of a three-dimensional modeling apparatus;
Fig. 3 is a schematic plan view showing a configuration of a three-dimensional modeling apparatus;
Fig. 4 is a schematic view of one of printer heads, viewed from the lower part;
Fig. 5 is a schematic view of a materials supply system in which a modeling material and a supporting material are supplied to both printer heads respectively;
Fig. 6 is a schematic view showing the halfway state of a three-dimensional model prepared while operating a three-dimensional modeling apparatus; and
Fig. 7A is a schematic view showing a model accompanied by supporting materials after the completion of forming, and Fig. 7B is a schematic view showing a model obtained by removing the supporting materials from the model accompanied by the supporting materials after the completion of forming.

### DETAILED DESCRIPTION OF PREFFERRED EMBODIMENTS

The present modeling material includes a monofunctional ethylenically unsaturated monomer (A) free from a urethane group and allowing a homopolymer thereof to have a glass transition temperature (Tg) of ≥ 80°C, a polyfunctional ethylenically unsaturated monomer (B) free from a urethane group and allowing a homopolymer thereof to have a Tg of ≥ 200°C, an ethylenically unsaturated monomer (C) having a urethane group and a photopolymerization initiator (D).

### [Monofunctional ethylenically unsaturated monomer (A)]

The monomer (A) is a compound having one ethylenically unsaturated group [such as a (meth)acryloyl group or a vinyl group] and is a monofunctional ethylenically unsaturated monomer free from a urethane group and allowing a homopolymer thereof to have a Tg of ≥ 80°C.

The present modeling material essentially contains a monomer (A) as defined above.

From the viewpoint of heat resistance of the photocured product, the monomer (A) allows a homopolymer thereof to have a Tg of ≥ 80°C, and the Tg is preferably 85-190°C and further preferably 90-185°C.

Examples of (A) include linear or branched C₄₋₃₀-alkyl (meth)acrylates [such as methyl (meth)acrylate and tert-butyl (meth)acrylate], (meth)acrylates having an alicyclic skeleton with 6-20 carbon atoms [such as cyclohexyl (meth)acrylate, 4-t-cyclohexyl (meth)acrylate, isobornyl (meth)acrylate, dicyclopentanyl (meth)acrylate and adamantyl (meth)acrylate], and (meth)acrylates having a heterocyclic skeleton [such as 4-(meth)acryloyloxymethyl-2-cyclohexyl-1,3-dioxolane].

Among the examples of (A), from the viewpoints of allowing the modeling material to stand the working temperature (50-90°C) on curing and working accuracy and heat resistance of the photocured product, preferred is a (meth)acrylate having an alicyclic skeleton, and further preferred are isobornyl (meth)acrylate, dicyclopentanyl (meth)acrylate and adamantyl (meth)acrylate.

The number average molecular weight (hereinafter, abbreviated as Mn) in the present invention is measured, for example, using HLC-8320GPC (available from TOSOH CORPORATION) as a gel permeation chromatography (GPC) apparatus, in a tetrahydrofuran solvent, with a TSK standard polystyrene [available from TOSOH CORPORATION] as a reference substance, at a measurement temperature: 40°C, with a column: Alliance (available from Nihon Waters K.K.), and using GPC workstation EcoSEC-WS [available from TOSOH CORPORATION] as analyzing software.

One kind of (A) may be used alone, or two or more kinds thereof may be combinedly used.

### [Polyfunctional ethylenically unsaturated monomer (B)]

The monomer (B) is a compound free from a urethane group and having two or more ethylenically unsaturated groups, and is a polyfunctional ethylenically unsaturated monomer free from a urethane group and allowing a homopolymer thereof to have a Tg of ≥ 200°C.

From the viewpoint of heat resistance of the photocured product, the Tg of the homopolymer of a monomer (B) is ≥ 200°C, preferably 205-230°C and further preferably 210-220°C.

Examples of (B) include linear or branched alkyleneglycol di-, tri- or tetra(meth)acrylates with 5-30 carbon atoms [such as pentaerythritol tri(meth)acrylate, trimethylolpropane tri(meth)acrylate and trimethylolpropane tetra(meth)acrylate]; di(meth)acrylates having an alicyclic skeleton with 10-30 carbon atoms [such as dimethylol-tricyclodecane dimethacrylate]; anddi(meth)acrylates having an aromatic ring with 10-40 carbon atoms [such as bisphenoxy fluorene di(meth)acrylate].

Among the examples of (B), from the viewpoints of allowing the modeling material to stand the working temperature (50-90°C) on curing and heat resistance of the photocured product, preferred are a di(meth)acrylate having an alicyclic skeleton and/or a di(meth)acrylate having an aromatic ring, and further preferred are dimethylol-tricyclodecane dimethacrylate and/or bisphenoxy fluorene di(meth)acrylate.

One kind of (B) may be used alone, or two or more kinds thereof may be combinedly used.

Moreover, since it is possible to raise the Tg while suppressing the curing shrinkage by allowing a bulky methacrylic group to be incorporated into (B), high heat resistance can be exhibited while suppressing the warpage of the fabrication product. On this account, among the examples of (B), especially preferred are polyfunctional ethylenically unsaturated monomers having a methacrylic group in their molecules.

Even among those, from the viewpoint of high heat resistance, especially preferred are dimethylol-tricyclodecane dimethacrylate and bisphenoxy fluorene dimethacrylate.

Moreover, by adopting the above-described constitution allowing (B) to have an alicyclic skeleton and/or an aromatic ring, furthermore, there is an effect that high heat resistance is exhibited while suppressing the warpage of the fabrication product.

### [Ethylenically unsaturated monomer (C) having urethane group]

The monomer (C) is a polyfunctional ethylenically unsaturated monomer (C1) having a urethane group. By allowing the present modeling material to contain (C), it is possible to further enhance the heat resistance of the photocured product.

One kind of (C) may be used alone, or two or more kinds thereof may be combinedly used.

Examples of the monomer (C1) include one that is formed from a polyol (α), an organic polyisocyanate (β) and a (meth)acrylate (γ) having a hydroxyl group, and one that is formed from an organic polyisocyanate (β) and a (meth)acrylate (γ) having a hydroxyl group.

Examples of the polyol (α) include a C₂₋₁₂-alkylene oxide (hereinafter, "alkylene oxide" is abbreviated as "AO") adduct (α1) of an aliphatic polyhydric alcohol, and a C₂₋₆-AO adduct (α2) of a dihydric phenol compound.

Examples of the aliphatic polyhydric alcohol used for (α1) include a linear or branched aliphatic dihydric C₂₋₁₂-alcohol [such as linear alcohols such as ethylene glycol, 1,3-propylene glycol, 1,4-butanediol, 1,5-pentanediol, 1,6-hexanediol, 1,7-heptanediol, 1,8-octanediol, 1,9-nonanediol and 1,10-dodecanediol; branched alcohols such as 1,2-, 1,3- or 2,3-butanediol, 2-methyl-1,4-butanediol, neopentyl glycol, 2,2-diethyl-1,3-propanediol, 2-methyl-1,5-pentanediol and 3-methyl-1,5-pentanediol]; alicyclic dihydric C₆₋₂₀-alcohols [such as 1,4-cyclohexanediol, 1,3-cyclohexanedimethanol, 1,4-cyclohexanediol, 1,3-cyclopentanediol, 1,4-cycloheptanediol, 1,4-bis(hydroxymethyl)cyclohexane and 2,2-bis(4-hydroxycyclohexyl)propane]; trihydric C₃₋₂₀-alcohols [such as aliphatic triols (such as glycerin and trimethylol propane)]; and tetra- to octahydric C₅₋₂₀-alcohols [such as aliphatic polyols (such as pentaerythritol, sorbitol, mannitol, sorbitan, diglycerin and dipentaerythritol); and saccharides (sucrose, glucose, mannose, fructose, methyl glucoside and a derivative thereof)].

Examples of the dihydric phenol compound used for (α2) include monocyclic phenols (such as catechol, resorcinol and hydroquinone), condensed polycyclic phenols (such as dihydroxynaphthalene) and bisphenol compounds (such as bisphenol A, bisphenol F and bisphenol S).

Examples of the C₂₋₁₂-AO used for (α1) and (α2) include ethylene oxide (hereinafter, abbreviated as EO), propylene oxide (hereinafter, abbreviated as PO), 1,2-, 2,3- or 1,3-butylene oxide, tetrahydrofuran, 3-methyltetrahydrofuran, α-olefin oxide and styrene oxide, and it is preferred that the number of carbon atoms of the AO be 2-4 from the viewpoint of heat resistance.

It is preferred that the number of moles added of the AO in (α1) and (α2) be 1-20 per one hydroxyl group from the viewpoint of heat resistance.

Specific examples of (α1) include a 5-mol EO adduct of 1,4-butanediol, a 5-mole PO adduct of 1,6-hexanediol, a 5-mole butylene oxide adduct of neopentyl glycol, PEG, PPG, and polyoxytetramethylene glycol (hereinafter, abbreviated as PTMG).

Specific examples of (α2) include a 4-mol EO adduct of resorcinol, a 4-mole PO adduct of dihydroxynaphthalene, and a 2-mol EO adduct of bisphenol A, bisphenol F or bisphenol S.

Among the examples of the polyol (α), from the viewpoint of toughness of the photocured product, preferred is (α1), further preferred are PEG, PPG and PTMG, and especially preferred is PPG.

Examples of the organic polyisocyanate (β) include an alicyclic C₈₋₁₈-polyisocyanate (β1), an aromatic C₈₋₂₆-polyisocyanate (β2), an aliphatic C₄₋₂₂-polyisocyanate (β3) and an aromatic-aliphatic C₁₀₋₁₈-polyisocyanate (β4). One kind of (β) may be used alone, or two or more kinds thereof may be combinedly used.

Examples of the alicyclic C₈₋₁₈-polyisocyanate (β1) include isophorone diisocyanate (hereinafter, abbreviated as IPDI), 2,4- or 2,6-methylcyclohexane diisocyanate (hereinafter, abbreviated as a hydrogenated TDI), dicyclohexylmethane-4,4'-diisocyanate (hereinafter, abbreviated as a hydrogenated MDI), cyclohexylene diisocyanate, methylcyclohexylene diisocyanate, bis(2-isocyanatoethyl)-4-cyclohexylene-1,2-dicarboxylate, 2,5- or 2,6-norbornane diisocyanate, and dimer acid diisocyanate.

Examples of the aromatic C₈₋₂₆-polyisocyanate (β2) include 1,3- or 1,4-phenylene diisocyanate, 2,4- or 2,6-tolylene diisocyanate (hereinafter, abbreviated as TDI), 4,4'- or 2,4'-diphenylmethane diisocyanate (hereinafter, abbreviated as MDI), m- or p-isocyanatophenylsulfonyl isocyanate, 4,4'-diisocyanatobiphenyl, 3,3'-dimethyl-4,4'-diisocyanatobiphenyl, 3,3'-dimethyl-4,4'-diisocyanatodiphenylmethane, 1,5-naphthylene diisocyanate, and m- or p-isocyanatophenylsulfonyl isocyanate.

Examples of the aliphatic C₄₋₂₂-polyisocyanate (β3) include ethylene diisocyanate, tetramethylene diisocyanate, hexamethylene diisocyanate (hereinafter, abbreviated as HDI), heptamethylene diisocyanate, octamethylene diisocyanate, nonamethylene diisocyanate, decamethylene diisocyanate, dodecamethylene diisocyanate, 2,2,4- or 2,4,4-trimethylhexamethylene diisocyanate, lysine diisocyanate, 2,6-diisocyanatomethylcaproate, 2,6-diisocyanatoethylcaproate, bis(2 -isocyanatoethyl)fumarate, bis(2-isocyanatoethyl)carbonate and trimethylhexamethylene diisocyanate (hereinafter, abbreviated as TMDI).

Examples of the aromatic-aliphatic C₁₀₋₁₈-polyisocyanate (β4) include m- or p-xylylene diisocyanate (hereinafter, abbreviated as XDI), and α,α,α',α'-tetramethylxylylene diisocyanate (hereinafter, abbreviated as TMXDI).

Among these examples of the organic polyisocyanate (β), from the viewpoint of toughness of the photocured product, preferred is the alicyclic C₈₋₁₈-polyisocyanate (β1), further preferred are IPDI and a hydrogenated MDI, and especially preferred is a hydrogenated MDI.

Examples of the (meth)acrylate (γ) having a hydroxyl group include a C₅₋₂₀-(poly)oxyalkylene (meth)acrylate (γ1), an ε-caprolactone adduct (having a chemical formula weight or Mn of 230-5,000) (γ2) of (yl), a reaction product (γ3) of (meth)acrylic acid and a diol (Mn of 300-5,000), a reaction product (with 8-30 carbon atoms) (γ4) of (meth)acrylic acid and an epoxide, and a reaction product (γ5) of (meth)acrylic acid and a 3 or more functional polyol (having a chemical formula weight or Mn of 92-5,000). One kind of (γ) may be used alone, or two or more kinds thereof may be combinedly used.

Examples of the C₅₋₂₀-(poly)oxyalkylene (meth)acrylate (γ1) include (meth)acrylic acid 2-hydroxyethyl ester [sometimes referred to as 2-hydroxyethyl acrylate], (meth)acrylic acid 2-hydroxypropyl ester, (meth)acrylic acid 2-hydroxybutyl ester, and an AO adduct thereof.

Examples of the ε-caprolactone adduct (having a chemical formula weight or Mn of 230-5,000) (γ2) of (γ1) include a (meth)acrylic acid 2-hydroxyethyl-ε-caprolactone 2-mole adduct.

Examples of the reaction product (γ3) of (meth)acrylic acid and a diol (Mn of 300-5,000) include a mono(meth)acrylate of a diol [Mn of 300-5,000, such as polycarbonate diol, PEG and polyester diol].

Examples of the reaction product (with 8-30 carbon atoms) (γ4) of (meth)acrylic acid and an epoxide include 3-phenoxy-2-hydroxypropyl (meth)acrylate and 3-biphenoxy-2-hydroxypropyl (meth)acrylate.

Examples of the reaction product (γ5) of (meth)acrylic acid and a 3 or more functional polyol (having a chemical formula weight or Mn of 92-5,000) include glycerin mono- or di(meth)acrylate, trimethylolpropane mono- or di(meth)acrylate, pentaerythritol mono-, di- or tri(meth)acrylate, ditrimethylolpropane mono-, di- or tri(meth)acrylate, dipentaerythritol mono-, di-, tri-, tetra- or penta(meth)acrylate, and an AO adduct thereof (the number of AO added of 1-100 per one hydroxyl group).

Among these examples of the (meth)acrylate (γ) having a hydroxyl group, from the viewpoint of toughness of the photocured product, preferred are (γ1) and (γ2), and further preferred is (γ1).

Among the examples of (C), from the viewpoint of heat resistance, preferred is a bifunctional ethylenically unsaturated monomer having a urethane group.

From the viewpoint of heat resistance of the photocured product the urethane group concentration of the monomer (C) is 2.7-5.0 mmol/g and preferably 2.9-4.8 mmol/g.

From the viewpoints of impact resistance and working accuracy of the photocured product and ease of handling of the composition, the Mn of (C) is preferably 500-5,000 and further preferably 700-2,000.

The monomer (C) in the present invention is obtained by allowing a (meth)acrylate (γ) having a hydroxyl group and a urethane prepolymer (δ) having an isocyanate group obtained by the reaction of a polyol (α) and an organic polyisocyanate (β) or an organic polyisocyanate (β) to undergo a reaction. The reaction temperature is preferably 50-140°C and further preferably 60-120°C.

In the reaction, to promote the reaction, a urethanization catalyst, which is used in a usual urethanization reaction, may be employed as necessary. Examples of the urethanization catalyst include a metal compound (such as an organobismuth compound, an organotin compound and an organotitanium compound), a tertiary amine, an amidine compound, and a quaternary ammonium salt.

From the viewpoints of reactivity and transparency of (C), on the basis of the weight of (C), the amount of the urethanization catalyst used is preferably not more than 1 wt.%, further preferably 0.001-0.5 wt.%, and especially preferably 0.05-0.2 wt.%.

### [Photopolymerization initiator (D)]

Examples of the photopolymerization initiator (D) include:
benzoin compounds [a compound with 14-18 carbon atoms such as benzoin, benzoin methyl ether, benzoin ethyl ether, benzoin propyl ether and benzoin isobutyl ether];
acetophenone compounds [a compound with 8-18 carbon atoms such as acetophenone, 2,2-diethoxy-2-phenylacetophenone, 2,2-diethoxy-2-phenylacetophenone, 1,1-dichloroacetophenone, 2-hydroxy-2-methyl-phenylpropan-1-one, diethoxyacetophenone, 1-hydroxycyclohexylphenyl ketone and 2-methyl-1-[4-(methylthio)phenyl]-2-morpholinopropan-1-one];
anthraquinone compounds [a compound with 14-19 carbon atoms such as 2-ethylanthraquinone, 2-t-butylanthraquinone, 2-chloroanthraquinone and 2-amylanthraquinone];
thioxanthone compounds [a compound with 13-17 carbon atoms such as 2,4-diethylthioxanthone, 2-isopropylthioxanthone and 2-chlorothioxanthonel;
ketal compounds [a compound with 16-17 carbon atoms such as acetophenone dimethyl ketal and benzil dimethyl ketal];
benzophenone compounds [a compound with 13-21 carbon atoms such as benzophenone, 4-benzoyl-4'-methyldiphenyl sulfide and 4,4'-bismethylaminobenzophenone];
phosphine oxide compounds [a compound with 22-28 carbon atoms such as 1,3,5-trimethylbenzoyldiphenylphosphine oxide, 2,4,6-trimethylbenzoyldiphenylphosphine oxide, bis-(2,6-dimethoxybenzoyl)-2,4,4-trimethylpentylphosphine oxide and bis(2,4,6-trimethylbenzoyl)-phenylphosphine oxide];
and mixtures thereof.

One kind of these examples of (D) may be used alone, or two or more kinds thereof may be combinedly used.

Among the above-mentioned examples of (D), from the viewpoint of light resistance such that the photocured product hardly turns yellow, preferred are an acetophenone compound and a phosphine oxide, further preferred are 1-hydroxycyclohexylphenyl ketone, 2-methyl-1-[4-(methylthio)phenyl]-2-morpholino-propan-1-one, 1,3,5-trimethylbenzoyldiphenylphosphine oxide, 2,4,6-trimethylbenzoyldiphenylphosphine oxide and bis-(2,6-dimethoxybenzoyl)-2,4,4-trimethylpentylphosphine oxide, and especially preferred are 1-hydroxycyclohexylphenyl ketone, 1,3,5-trimethylbenzoyldiphenylphosphine oxide and 2,4,6-trimethylbenzoyldiphenylphosphine oxide.

With regard to respective contents of (A), (B), (C) and (D) in the modeling material, on the basis of the weight of the modeling material, the content of (A) is preferably 50-90 wt.% and further preferably 55-85 wt.% from the viewpoints of enhancement in Tg and brittleness resistance of the photocured product; the content of (B) is preferably 3-25 wt.% and further preferably 4-20 wt.% from the viewpoints of mechanical strength and heat resistance of the photocured product; the content of (C) is preferably 5-35 wt.% and further preferably 8-30 wt.% from the viewpoints of toughness and reduction in warpage of the photocured product; and the content of (D) is preferably 0.1-10 wt.% and further preferably 0.3-8 wt.% from the viewpoints of photocuring rate and mechanical properties of the photocured product.

### [Additive agent (E)]

An additive agent (E) may be contained in the modeling material as necessary as long as the effect of the present invention is not impaired.

Examples of (E) include a polymerization inhibitor, a surfactant, a coloring agent, an oxidation inhibitor, a chain transfer agent and a filler. The additive agent may be selected from various types of additive agents according to the purpose, and one kind thereof may be used alone, or two or more kinds thereof may be combinedly used.

In the present method of producing a photofabrication model described later, although the working temperature varies with the ink-jet method, the temperature is 50-90°C in many instances and it is preferred to employ a polymerization inhibitor from the viewpoints of avoidance of the runaway polymerization and enhancement in stability of the monomer in the apparatus.

Examples of the polymerization inhibitor include phenol compounds [such as hydroquinone, hydroquinone monomethyl ether, 2,6-di-t-butyl-p-cresol, 2,2-methylene-bis-(4-methyl-6-t-butylphenol) and 1,1,3-tris-(2-methyl-4-hydroxy-5-t-butylphenyl)butane], sulfur compounds [such as dilauryl thiodipropionate], phosphorus compounds [such as triphenyl phosphite], and amine compounds [such as phenothiazine].

The amount of the polymerization inhibitor used is usually not more than 5 wt.%, and is preferably 0.05-3 wt.% from the viewpoints of stability and polymerization rate of the monomer, on the basis of the total weight of (A), (B), (C) and (D).

Examples of the surfactant include one that has a chemical formula weight or Mn of 246-5,000, a PEG-based nonionic surfactant [such as a 1- to 40-mol EO adduct of nonylphenol, and a 1- to 40-mol EO adduct of stearic acid], a polyhydric alcohol-based nonionic surfactant (such as a sorbitan palmitic acid monoester, a sorbitan stearic acid monoester and a sorbitan stearic acid triester), a fluorine-containing surfactant (such as a 1- to 50-mol perfluoroalkyl EO adduct, a perfluoroalkyl carboxylate and a perfluoroalkyl betaine) and a modified silicone oil [such as a polyether-modified silicone oil (for example, a polyether-modified polydimethyl siloxane,) and a (meth)acrylate-modified silicone oil].

On the basis of the total weight of (A), (B), (C) and (D), the amount of the surfactant used is usually not more than 3 wt.% and preferably 0.05-2 wt.% from the viewpoints of addition effects and physical properties of the photocured product.

Examples of the coloring agent include a pigment and/or a dye. Examples of the pigment include organic and inorganic pigments and the following agents can be mentioned as examples.
(1) an azo pigment such as an insoluble monoazo pigment (such as toluidine red, permanent carmine FB and fast yellow G), an insoluble disazo pigment (such as disazo yellow AAA and disazo orange PMP), an azo lake (a soluble azo pigment) (such as lake red C and brilliant carmine 6B), a condensed azo pigment and a chelate azo pigment;
(2) a polycyclic pigment such as phthalocyanine blue, indanthrone blue, quinacridone red and dioxazine violet;
(3) a dye lake such as a basic dye (such as victoria pure blue BO lake) and an acid dye (such as alkali blue toner); and
(4) others such as an azine pigment (such as aniline black), a daylight fluorescent pigment, a nitroso pigment, a nitro pigment and a natural pigment.

Examples of the inorganic pigment include a metal oxide (such as iron oxide, chromium oxide and titanium oxide) and carbon black.

The amount of the coloring agent used is usually not more than 2 wt.%, and is preferably 0.05-1 wt.% from the viewpoints of coloration effects and physical properties of the photocured product, on the basis of the total weight of (A), (B), (C) and (D).

Examples of the oxidation inhibitor include phenol compounds {such as monocyclic phenols (2,6-di-t-butyl-p-cresol), bisphenols [such as 2,2'-methylenebis(4-methyl-6-t-butylphenol)] and polycyclic phenols [such as 1,3,5-trimethyl-2,4,6-tris(3,5-di-t-butyl-4-hydroxybenzyl)benzenel }, sulfur compounds (such as dilauryl 3,3'-thiodipropionate), phosphorus compounds (such as triphenyl phosphite) and amine compounds (such as octylated diphenylamine).

The amount of the oxidation inhibitor used is usually not more than 3 wt.%, and is preferably 0.1-2 wt.% from the viewpoints of antioxidant effects and physical properties of the photocured product, on the basis of the total weight of (A), (B), (C) and (D).

Examples of the chain transfer agent include hydrocarbons [a compound with 6-24 carbon atoms such as an aromatic hydrocarbon (such as toluene and xylene) and an unsaturated aliphatic hydrocarbon (such as 1-butene and 1-nonene)]; halogenated hydrocarbons (a compound with 1-24 carbon atoms such as dichloromethane and carbon tetrachloride); alcohols (a compound with 1-24 carbon atoms such as methanol and 1-butanol); thiols (a compound with 1-24 carbon atoms such as ethylthiol and 1-octylthiol); ketones (a compound with 3-24 carbon atoms such as acetone and methyl ethyl ketone); aldehydes (a compound with 2-18 carbon atoms such as 2-methyl-2-propyl aldehyde and 1-pentyl aldehyde); phenols (a compound with 6-36 carbon atoms such as phenol and m-, p- and o-cresol); quinones (a compound with 6-24 carbon atoms such as hydroquinone); amines (a compound with 3-24 carbon atoms such as diethylmethylamine and diphenylamine); and disulfides (a compound with 2-24 carbon atoms such as diethyl disulfide and di-1-octyl disulfide).

The amount of the chain transfer agent used is usually not more than 10 wt.%, and is preferably 0.05-5 wt.% from the viewpoints of polymerizability of the monomer and compatibility of the monomer and the chain transfer agent, on the basis of the total weight of (A), (B), (C) and (D).

Examples of the filler include metal powders (such as aluminum powder and copper powder), metal oxides (such as alumina, silica, talc, mica and clay), metal hydroxides (such as aluminum hydroxide), metal salts (such as calcium carbonate and calcium silicate), fibers [such as inorganic fibers (such as carbon fibers, glass fibers and asbestos), organic fibers (such as cotton, nylon, acrylic and rayon fibers)], microballoon (such as glass, shirasu and phenolic resin), carbon (such as carbon black, graphite and coal powder), metal sulfides (such as molybdenum disulfide), and organic powders (such as wood dust).

The amount of the filler used is usually not more than 30 wt.%, and is preferably 3-20 wt.% from the viewpoints of packing effects, viscosity that allows ink-jet discharge and physical properties of the photocured product, on the basis of the total weight of (A), (B), (C) and (D).

The total amount of (E) used is usually not more than 30 wt.%, and is preferably 0.05-20 wt.% from the viewpoints of addition effects and physical properties of the photocured product, on the basis of the total weight of (A), (B), (C) and (D).

From the viewpoints of heat resistance of the photocured product and reduction in warpage of the photocured product, the Tg of the photocured product of the modeling material is preferably 91-200°C, further preferably 95-190°C, and especially preferably 100-180°C. The Tg of the photocured product can be adjusted so as to fall within the above-mentioned range by selecting the kind and content of respective ingredients (A), (B), (C) and (D) constituting the modeling material.

The Tg of the photocured product in the present invention can be measured by the following method.

### (1) Preparation method of test specimen

A 10-cm by 10-cm square area is separated by means of spacers of 1 mm in thickness arranged as four sides on the top surface of a glass plate [trade name "GLASS PLATE," available from AS ONE Corporation, 200-mm by 200-mm by 5 mm in thickness]. Into the square area, a modeling material is poured, after which a glass plate of the same type is overlapped. After irradiated with ultraviolet rays of 1000 mJ/cm² with an ultraviolet irradiation device [model number "ECS301G1," available from EYE GRAPHICS CO., LTD.], the photocured product is removed from the glass plate and cut into pieces of 5 mm in width by 40 mm in length by a cutter to give test specimens.

### (2) Measurement method of Tg

Using a test specimen obtained in (1), the Tg is measured at 10 Hz by a DMA method using a stretch mode with a dynamic viscoelasticity measuring apparatus (DMA) [model number "Rheogel-E4000," available from UBM].

The present modeling material is used as a modeling material employed for a two-pack type photocurable composition prepared by combining the modeling material for forming a photofabrication model in ink-jet stereo lithography and a supporting material supporting the shape of the photofabrication model on photofabrication. Although known supporting materials may be used as the supporting material combinedly used in the two-pack type photocurable composition, from the viewpoints of ease of removal after photofabrication and working accuracy of the photofabrication model, it is preferred that the following supporting material be used.

### [Supporting material]

The supporting material preferably used in the present invention includes a water-soluble monofunctional ethylenically unsaturated monomer (F), an AO adduct containing an oxypropylene group and/or water (G), and a photopolymerization initiator (H).

### [Water-soluble monofunctional ethylenically unsaturated monomer (F)]

The water-soluble monofunctional ethylenically unsaturated monomer (F) is employed as a constituent ingredient of the supporting material to allow the cured product of the supporting material to dissolve rapidly in water after photofabrication.

Examples of (F) include hydroxyl group-containing C₅₋₁₅-(meth)acrylates [such as hydroxyethyl (meth)acrylate, hydroxypropyl (meth)acrylate and 4-hydroxybutyl (meth)acrylate]; hydroxyl group-containing (meth)acrylates with an Mn of 200-1,000 [such as PEG mono(meth)acrylate, monoalkoxy (C₁₋₄) polyethylene glycol mono(meth)acrylate, PPG mono(meth)acrylate, monoalkoxy (C₁₋₄) polypropylene glycol mono(meth)acrylate and mono(meth)acrylate of PEG-PPG block polymer]; C³⁻¹⁵-(meth)acrylamide derivatives [such as (meth)acrylamide, N-methyl (meth)acrylamide, N-ethyl (meth)acrylamide, N-propyl (meth)acrylamide, N-butyl (meth)acrylamide, N,N'-dimethyl (meth)acrylamide, N,N'-diethyl (meth)acrylamide, N-hydroxyethyl (meth)acrylamide, N-hydroxypropyl (meth)acrylamide and N-hydroxybutyl (meth)acrylamide] and (meth)acryloyl morpholine. One kind of (F) may be used alone, or two or more kinds thereof may be combinedly used.

Among the examples of (F), from the viewpoint of photoreactivity, preferred are hydroxyl group-containing C₅₋₁₅-acrylates, C₃₋₁₅-acrylamide derivatives and (meth)acryloyl morpholine, and further preferred are hydroxyethyl acrylate, hydroxypropyl acrylate and 4-hydroxybutyl acrylate, acrylamide, acryloyl morpholine, N-methyl acrylamide, N-ethyl acrylamide, N-propyl acrylamide, N-butyl acrylamide, N,N'-dimethyl acrylamide, N,N'-diethyl acrylamide, N-hydroxyethyl acrylamide, N-hydroxypropyl acrylamide and N-hydroxybutyl acrylamide. Moreover, from the viewpoint of low stimulative effect on the skin of the human body, preferred are acryloyl morpholine and N-hydroxyethyl acrylamide.

### [AO adduct containing oxypropylene group and/or water (G)]

With regard to (G), examples of an AO adduct containing an oxypropylene group include one obtained by subjecting an active hydrogen compound to an addition reaction of at least PO alone or of PO and any other AO. Among these, preferred is one obtained by subjecting an active hydrogen compound to an addition reaction of PO alone (for example, PPG). Examples of the active hydrogen compound include a mono- to tetrahydric alcohol, an amine compound and water, and among these, preferred are a dihydric alcohol and water.

As (G), from the viewpoint of achieving both the supporting strength and the solubility in water of the cured product of the supporting material, preferred are PPG with an Mn of 100-5,000 which is compatible with (F) before curing and is not compatible with the photocured product of (F) and/or water. The Mn of the PPG is preferably 200-3,000 and further preferably 400-2,000.

On the other hand, from the viewpoint of prevention of compatibilization or prevention of intermixing of the modeling material and the supporting material before curing, preferred is water. In the case where (G) is water, since the modeling material and the supporting material before curing do not compatibilize or intermix with each other, a problem of decreased various physical properties at an intermixed part of each of the cured products of the modeling material and the supporting material and a problem of swelling deformation, resulting from the problem of compatibilization and intermixing of the modeling material and the supporting material before curing, may be completely solved.

### [Photopolymerization initiator (H)]

As a photopolymerization initiator used for the supporting material, one that is the same as the photopolymerization initiator (D) for the modeling material is basically used. In the case where (G) is water, a water-soluble photopolymerization initiator is used.

Among the examples of (H), as the water-soluble photopolymerization initiator, 1-[4-(2-hydroxyethoxy)phenyl]-2-methyl-1-propan-1-one can be mentioned and it is not particularly limited as long as it is water-soluble.

The contents of (F), (G) and (H) in the supporting material are preferably 3-45 wt.%, further preferably 3-43 wt.%, especially preferably 4-40 wt.% of (F) from the viewpoint of allowing the photocured product of the supporting material to remain solid and to exert the supporting strength and the viewpoint of solubility in water of the photocured product; preferably 50-95 wt.%, further preferably 53-93 wt.%, especially preferably 55-90 wt.% of (G) from the viewpoints of solubility in water of the photocured product and supporting strength; and preferably 0.1-10 wt.%, further preferably 0.3-8 wt.%, especially preferably 0.5-6 wt.% of (H) from the viewpoints of photocuring properties of the supporting material and solubility in water of the photocured product.

### [Additive agent (E)]

An additive agent (E) may be contained in the supporting material as necessary as long as the effect of the present invention is not impaired.

Ones that are the same as the additive agent (E) used for the modeling material may be used for the supporting material.

Examples of (E) include a polymerization inhibitor, a coloring agent, an oxidation inhibitor, a chain transfer agent and a filler. The additive agent may be selected from various types of additive agents according to the purpose, and one kind thereof may be used alone, or two or more kinds thereof may be combinedly used.

Each of the amounts of (E) used (wt.%) based on the total weight of (F), (G) and (H) is the same as each of the amounts of (E) used (wt.%) based on the total weight of (A), (B), (C) and (D) in the modeling material. Moreover, the total amount of (E) used (wt.%) based on the total weight of (F), (G) and (H) is also the same as the total amount of (E) used (wt.%) based on the total weight of (A), (B), (C) and (D).

### [Production method of photofabrication model]

The present photofabrication model is usually produced by the following procedure using a photofabrication apparatus described later.

### (1) Production of modeling material and supporting material

### (1-1) Production of modeling material

(A), (B), (C) and (D) and an optionally added additive agent (E) are uniformly mixed using e.g. a mixing and stirring device to produce a modeling material.

### (1-2) Production of supporting material

(F), (G) and (H) and an optionally added additive agent (E) are uniformly mixed using e.g. a mixing and stirring device to produce a supporting material.

### (2) Production of photofabrication model with three-dimensional modeling system

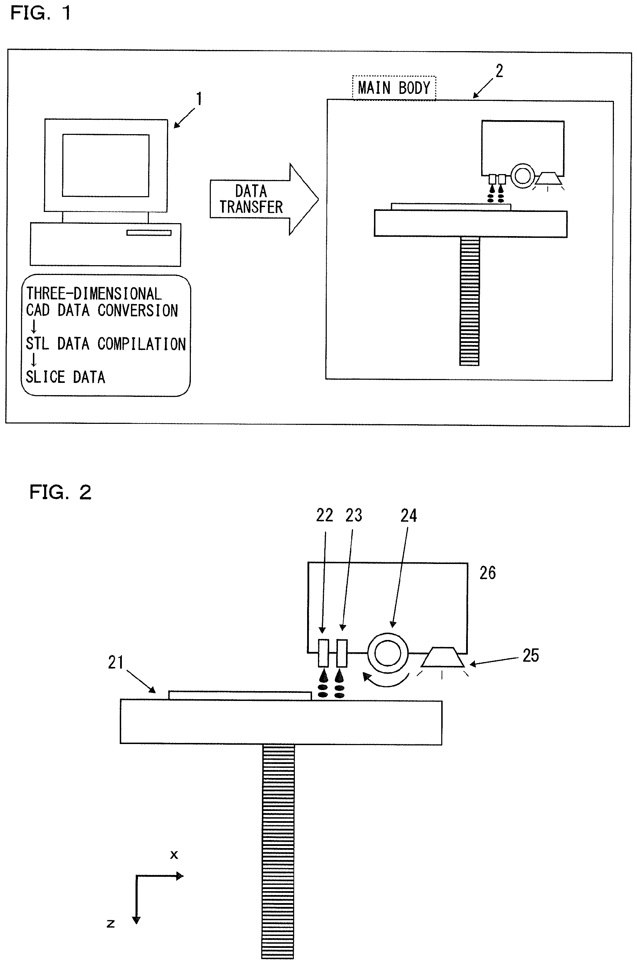

Fig. 1 is a schematic view of a three-dimensional modeling system employing an ink-jet method. As shown in Fig. 1, the system is composed of a personal computer (PC) 1 and a three-dimensional modeling apparatus 2 connected to the PC 1. The PC 1 accepts input of three-dimensional CAD data for an object to be formed, converts the inputted CAD data into, for example, STL (abbreviation of Stereo Lithography) data as three-dimensional modeling data, and further, from the three-dimensional STL data, creates data of each layer obtained by slicing the object in the z-direction.

Specifically, in addition to data for a modeling material corresponding to a work to be formed, data for a supporting material for supporting the modeling material on forming are also created. Generally, in the case where, for example, in the z-direction, the width of the modeling material located at an upper part thereof is larger than the width of the modeling material located at a lower part thereof, namely, the work has a so-called overhang part, the system is designed so that by arranging a supporting material around the lower part in the x- and y-directions using software installed in the PC 1, the supporting material is automatically provided and the overhang part is supported from the lower part.

Furthermore, the PC 1 has a function of positioning and determining the posture in the x-, y- and z-directions of three-dimensional data for modeling within a modeling space possessed by the three-dimensional modeling apparatus 2, while using the STL data. More specifically, it is made possible to display, on a display screen of the PC 1, a virtual three-dimensional space that three-dimensionally represents the modeling space above the modeling table possessed by the three-dimensional modeling apparatus 2 and to display three-dimensional STL data of the object to be formed at the default location of the space, and by using a pointing device such as a mouse and a cursor on the display screen, to determine the desired position and posture within the modeling space possessed by the three-dimensional modeling apparatus 2 using the three-dimensional STL data of the object to be formed.

The three-dimensional modeling apparatus 2 carries out the formation of each layer by receiving data of each layer obtained by slicing the object in the z-direction described above in a lump or in each layer aligned from the PC 1, allowing two-dimensional printer heads described later possessed by the three-dimensional modeling apparatus 2 to scan in a main scanning direction (x-direction) and a vertical scanning direction (y-direction) on the basis of the data of each layer, and discharging a modeling material and a supporting material from a printer head for modeling material discharge and a printer head for supporting material discharge, respectively.

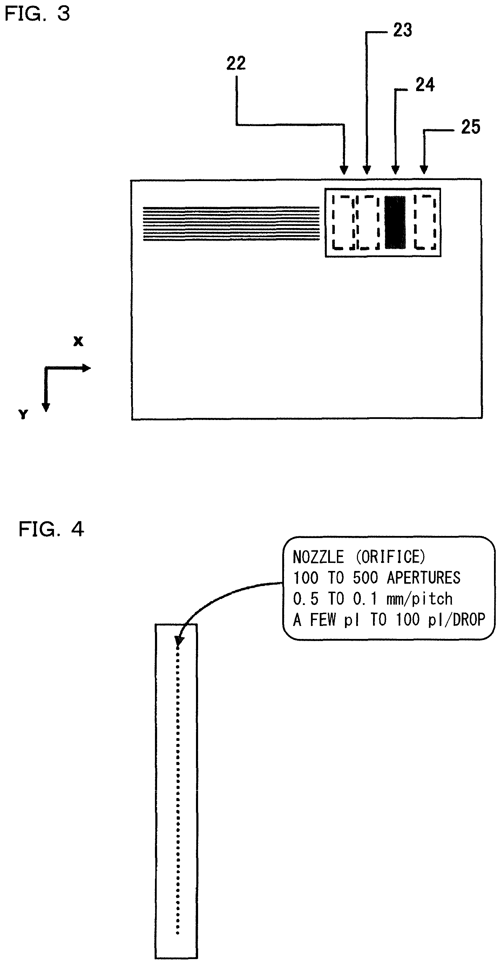

Fig. 2 and Fig. 3 are schematic views showing the configuration of the three-dimensional modeling apparatus 2, and Fig. 2 is a side view and Fig. 3 is a plan view.

As shown in Fig. 2 and Fig. 3, the three-dimensional modeling apparatus 2 has a modeling table 21 which is movable in the z-direction, a printer head 22 for modeling material for discharging a modeling material onto the modeling table, a printer head 23 for supporting material for discharging a supporting material onto the modeling table, a roller 24 for removing the excess modeling material and supporting material in order to smooth the top surface of the layer formed on the modeling table 21 after discharged from the printer heads 22 and 23, and a UV light source 25 for photocuring at least the modeling material applied.

The above-described printer heads 22 and 23, the roller 24 for smoothing, and the UV light source 25 are mounted in place on a printer head module 26 and integrally driven in a main scanning direction (x-direction) and a vertical scanning direction (y-direction) above the modeling table 21 by a driving apparatus which is not depicted.

Fig. 4 is a schematic view of one of printer heads 22 and 23, viewed from the lower part. As shown in Fig. 4, each of the printer heads 22 and 23 has plural orifices for discharging a modeling material or a supporting material disposed at predetermined intervals in the vertical scanning direction (y-direction) on the surface opposite to the modeling table.

In Fig. 2, when the module moves in a main scanning direction (a direction of forward movement) in which the module moves from the left side to the right side and a modeling material and a supporting material are discharged at least from the printer heads 22 and 23 onto the modeling table, the roller 24 works in the case where the module moves in a direction of backward movement in which the module moves from the right end of the main scanning direction to the left. On that occasion, the rotation direction of the roller is the direction of the arrow shown in Fig. 2, and thus, the roller revolves clockwise.

In other words, it is preferred that the printer head module 26 and the roller 24 be controlled so that the scanning direction of the printer head module 26 at the time when the roller 24 works and the direction in which the lower part of the roller 24 revolves (the direction of the arrow shown in Fig. 2) are aligned with each other.

The UV light source 25 extends along the vertical scanning direction and it is desirable that the length thereof be at least as long as the length ranging over all the orifices disposed on each printer head.

Moreover, as the UV light source 25, it is preferred to employ a UV lamp commonly frequently used for curing the photocurable resin or a LED.

Moreover, the modeling table 21 is moved, by a driving apparatus which is not depicted, downward (in the z-direction) by the thickness of each layer prior to the formation of the following layer every time each layer is formed on the basis of each slice data corresponding to each layer.

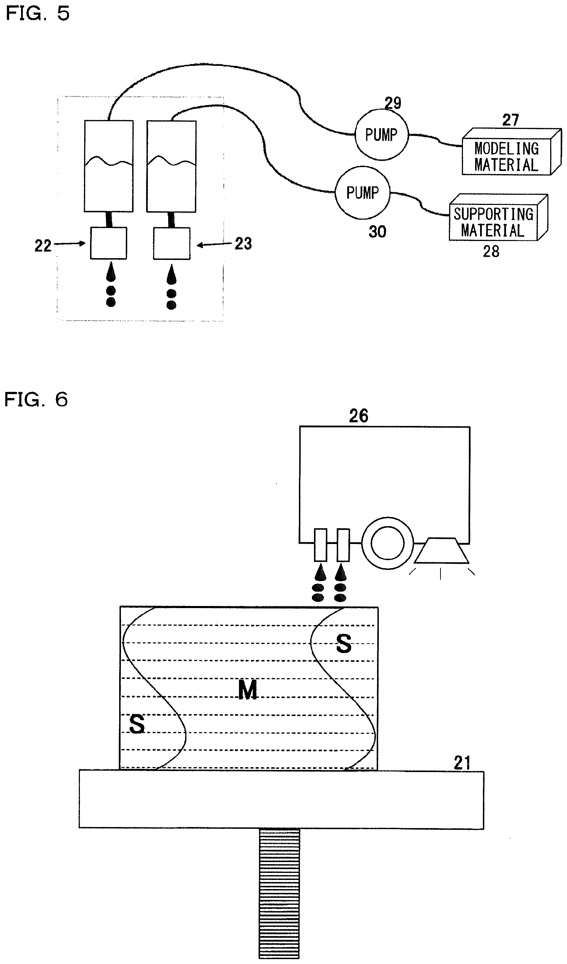

Fig. 5 is a schematic view of a materials supply system in which a modeling material and a supporting material are supplied to both printer heads 22 and 23 respectively.

To each of the printer heads 22 and 23, cartridges 27 and 28 containing a modeling material and a supporting material are connected respectively and into each of the intermediate connection routes, feed pumps 29 and 30 are inserted respectively. Each of the cartridges 27 and 28 is interchangeable in the case where the modeling material or the supporting material as the contents thereof has been consumed.

Next, a three-dimensional modeling method using the above-mentioned three-dimensional modeling system employing an ink-jet method will be described.

When CAD data for three-dimensional modeling are entered in the PC 1, the data are converted to STL data and after the posture of three-dimensional data (model) within the modeling space possessed by the three-dimensional modeling apparatus 2 is determined on the display screen described above, each slice data in the z-direction is transferred to the three-dimensional modeling apparatus 2 from the PC 1.

The three-dimensional modeling apparatus 2 stacks layers, each of which corresponds to each slice data, on top of each other on the modeling table by allowing the printer head module 26 to move back and forth in the main scanning direction and, while allowed to move back and forth, controlling the discharge of the modeling material and the supporting material from each of the printer heads 22 and 23 onto appropriate locations on the basis of each slice data received.

For each layer, at least the modeling material is discharged from the printer head 22 onto an appropriate location and, if necessary, the supporting material is also discharged from the printer head 23 onto an appropriate location to form each layer.

Furthermore, for example, when a modeling material and a supporting material are discharged from each of the printer heads 22 and 23 during the course of allowing the printer head module 26 to move in the direction from left to right in Fig. 2 (the direction of forward movement), the roller 24 continues to revolve in the above-described rotation direction during the course of allowing the module to move in the direction of backward movement (the direction from right to left in Fig. 2), while being in contact with the surfaces of the modeling material and the supporting material, in order to smooth the surface composed of the modeling material and the supporting material that have already been applied on the modeling table 21 and to remove the excess material.

Then, by irradiating the surface smoothed with the roller 24 with ultraviolet rays from the UV light source 25 mounted on the printer head module 26, the layer located on the top surface of the object formed on the modeling table 21 is allowed to be cured. In this connection, it goes without saying that each layer is formed from at least the modeling material and formed by being added with the supporting material if necessary.

Thus, the formation of each layer is carried out by discharging a modeling material and a supporting material from each of the printer heads 22 and 23, forming a layer located on the top surface of the object on the modeling table 21, smoothing the surface of the layer with the roller 24, and curing the layer by irradiating the layer located on the top surface of the object on the modeling table 21 with ultraviolet rays. By repeating these steps, a three-dimensional model is formed.

Fig. 6 is a schematic view showing the halfway state of a three-dimensional model prepared while operating a three-dimensional modeling apparatus 2. The portion represented by M shown in Fig. 6 is the portion of stacked layers formed from the modeling material and the portion represented by S is the portion of stacked layers formed from the supporting material.

As described above, the model is allowed to form so that the supporting materials are deposited on the portions represented by S in order to support the curved parts at the left and right of the modeling material shown in Fig. 6 since the modeling material of the portion represented by M has an approximately S-shape formed from the lower part to the upper part in the z-direction.

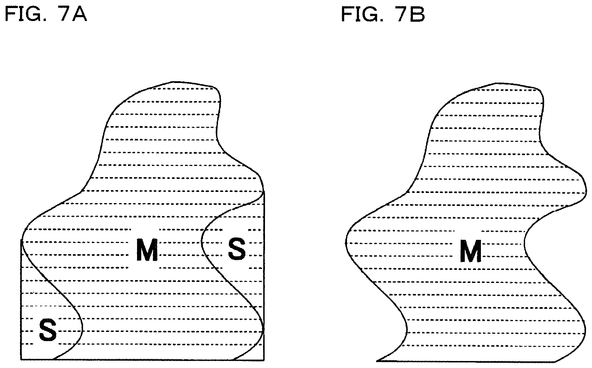

Fig. 7A is a schematic view showing a model accompanied by supporting materials after the completion of fabrication as described above, and Fig. 7B is a schematic view showing a model obtained by removing supporting materials from the model accompanied by the supporting materials after the completion of fabrication.

As shown in Fig. 7A, at the time of the completion of fabrication of a three-dimensional model by means of the three-dimensional modeling apparatus 2, the model is still integrally formed with supporting materials for supporting the modeling material during the fabrication. As such, since the supporting materials are composed of the water-soluble material, for example, by immersing the supporting materials in water, a model (a photofabrication model) composed only of the modeling material shown in Fig. 7B can be obtained. In this way, the photofabrication model according to the present invention can be obtained.

### EXAMPLES

Hereinafter, the present invention will be described in more detail by reference to examples, but the present invention is not limited thereto. It should be noted that part and % refer to part by weight and wt.% respectively unless otherwise stated.

### Production Example 1

In a reaction vessel, 232 parts of 2-hydroxyethyl acrylate [trade name "LIGHT ESTER HOA," available from Kyoeisha Chemical Co., LTD.], 222 parts of IPDI and 0.3 parts of a urethanization catalyst [bismuth tris(2-ethylhexanoate) (a 50 wt.% 2-ethylhexanoic acid solution); the same holds true for description below] were placed and allowed to undergo a reaction for 12 hours at 80°C to give an ethylenically unsaturated monomer (C-1) having a urethane group. The monomer (C-1) had a urethane group concentration of 4.4 mmol/g and an Mn of 686.

### Production Example 2

In a reaction vessel, 400 parts of PPG [trade name "PPG-400," available from Sanyo Chemical Industries, Ltd., Mn = 400], 524 parts of a hydrogenated MDI and 0.5 parts of a urethanization catalyst were placed and allowed to undergo a reaction for 4 hours at 80°C, after which 232 parts of 2-hydroxyethyl acrylate was added and allowed to undergo a reaction for 8 hours at 80°C to give an ethylenically unsaturated monomer (C-2) having a urethane group. The resultant monomer (C-2) had a urethane group concentration of 3.4 mmol/g and an Mn of 1,388.

### Production Example 3 (Reference, not according to the claimed invention)

In a reaction vessel, 1,000 parts of PTMG [trade name "PTMG-1000," available from Mitsubishi Chemical Corporation, Mn 1,000], 333 parts of IPDI and 0.5 parts of a urethanization catalyst were placed and allowed to undergo a reaction for 4 hours at 80°C, after which 116 parts of 2-hydroxyethyl acrylate was added (the isocyanate group/hydroxyl group equivalent ratio = 1/1) and allowed to undergo a reaction for 8 hours at 80°C to give an ethylenically unsaturated monomer (C-3) having a urethane group. The resultant monomer (C-3) had a urethane group concentration of 2.1 mmol/g and an Mn of 2,898.

### Examples 1-8 and Comparative Examples 1-5

By allowing raw materials to be uniformly mixed, respective modeling materials in examples and comparative examples having a blending composition (parts) listed in Table 1 were obtained, after which respective modeling materials were measured for the Tg of the photocured product, the deflection temperature under load, the strength on tearing apart and the deformation during storage by the following measurement methods. The results are shown in Table 1.

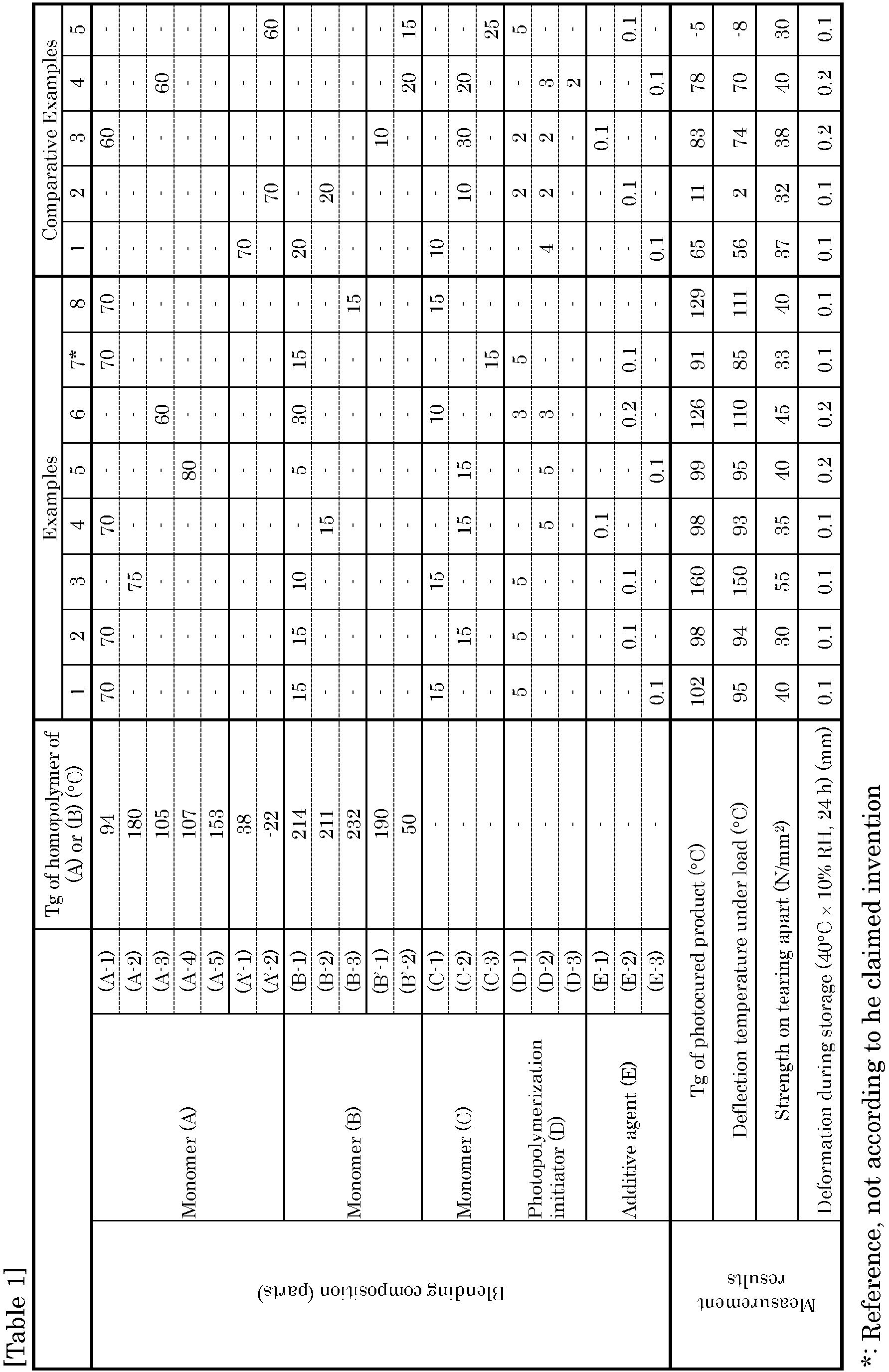

In this connection, the contents represented by symbols in Table 1 are as follows.
(A-1): isobornyl acrylate [trade name "LIGHT ACRYLATE IBXA," available from Kyoeisha Chemical Co., LTD., number of functional groups = 1]
(A-2): isobornyl methacrylate [trade name "LIGHT ESTER IB-X," available from Kyoeisha Chemical Co., LTD., number of functional groups = 1]
(A-3): methyl methacrylate [trade name "LIGHT ESTER M," available from Kyoeisha Chemical Co., LTD., number of functional groups = 1]
(A-4): tert-butyl methacrylate [trade name "LIGHT ESTER TB," available from Kyoeisha Chemical Co., LTD., number of functional groups = 1]
(A'-1): n-stearyl methacrylate [trade name "LIGHT ESTER S," available from Kyoeisha Chemical Co., LTD., number of functional groups = 1]
(A'-2): phenoxyethyl acrylate [trade name "LIGHT ACRYLATE PO-A," available from Kyoeisha Chemical Co., LTD., number of functional groups = 1]
(B-1): dimethylol-tricyclodecane dimethacrylate [trade name "LIGHT ESTER DCP-M," available from Kyoeisha Chemical Co., LTD., number of functional groups = 2]
(B-2): bisphenoxy fluorene diacrylate [trade name "A-BPEF," available from Shin Nakamura Chemical Co., Ltd., number of functional groups = 2]
(B-3): bisphenoxy fluorene dimethacrylate [trade name "BPEF-MA," available from Shin Nakamura Chemical Co., Ltd., number of functional groups = 2]
(B'-1): dimethylol-tricyclodecane diacrylate [trade name "LIGHT ACRYLATE DCP-A," available from Kyoeisha Chemical Co., LTD., number of functional groups = 2]
(B'-2): PEG (Mn 200) diacrylate [trade name "LIGHT ACRYLATE 4EG-A," available from Kyoeisha Chemical Co., LTD., number of functional groups = 2]
(D-1): 1,3,5-trimethylbenzoyldiphenyl phosphine oxide [trade name "Lucirin TPO," available from BASF Japan Ltd.]
(D-2): 1-hydroxycyclohexylphenyl ketone [trade name "IRGACURE 184," available from BASF Japan Ltd.]
(D-3): 2-methyl-1-[4-(methylthio)phenyl]-2-morpholinopropan-1-one [trade name "IRGACURE 907," available from BASF Japan Ltd.]
(E-1): polyether modified polydimethylsiloxane [trade name "BYK 307," available from BYK Japan KK] (a surfactant)
(E-2): hydroquinone monomethyl ether [available from Wako Pure Chemical Industries, Ltd.] (a polymerization inhibitor)
(E-3): carbon black [trade name "MHI Black #220," available from Mikuni Color LTD.] (a coloring agent)

### <Measurement method of Tg of photocured product of modeling material>

### (1) Preparation of test specimen

A 10-cm by 10-cm square area was separated by means of spacers of 1 mm in thickness arranged as four sides on the top surface of a glass plate [trade name "GLASS PLATE," available from AS ONE Corporation, 200-mm by 200-mm by 5 mm in thickness]. Into the square area, a modeling material was poured, after which a glass plate of the same type was overlapped. After irradiated with ultraviolet rays of 1000 mJ/cm² with an ultraviolet irradiation device [model number "ECS301G1," available from EYE GRAPHICS CO., LTD.], the photocured product was removed from the glass plate and cut into pieces of 5 mm in width by 40 mm in length by a cutter to give test specimens.

### (2) Measurement of Tg

Using a test specimen obtained in (1), the Tg was measured at 10 Hz by a DMA method using a stretch mode with a dynamic viscoelasticity measuring apparatus (DMA) [model number "Rheogel-E4000," available from UBM].

### <Measurement methods of deflection temperature under load, strength on tearing apart and deformation during storage of photocured product of modeling material>

With regard to test specimens obtained in the same manner as that in the preparation method of test specimens for measuring the Tg of the photocured product of the modeling material except that the object was irradiated with ultraviolet rays of 300 mJ/cm² and the length of the test specimen was set to 50 mm, the measurement was performed by the following methods (1)-(3). The measurement results are shown by the average value of 5 test specimens.

### (1) Deflection temperature under load

The deflection temperature under load was measured in accordance with JIS-K7191 using a measuring apparatus for deflection temperature under load [model number "148-HDPC-3," available from YASUDA SEIKI SEISAKUSHO, LTD.]. The load was set to the high load (1.8 MPa).

### (2) Strength on tearing apart (N/mm²)

The tensile strength on tearing apart was measured in accordance with JIS-K7113 by stretching a test specimen at a test rate of 50 mm/minute using Autograph [available from SHIMADZU CORPORATION] and defined as the strength on tearing apart.

### (3) Deformation during storage (mm)

One end in the lengthwise direction of a test specimen was fixed to a chuck (the distance for a grasp of 5 mm), and the test specimen in a state of being held horizontally was allowed to settle for 24 hours in a thermohygrostat (40°C, 10% RH), after which the distance between the other end of the test specimen, the other end being at a side opposite to the fixed end, being deformed because of gravity and being allowed to hang down, and the initial horizontal plane was measured and defined as the deformation during storage (mm).

The results shown in Table 1 reveal that the photocured product obtained by allowing the present modeling material (Examples 1-8) to be cured is higher in deflection temperature under load and is more excellent in heat resistance than the photocured product obtained by allowing the modeling material for comparison (Comparative Examples 1-5) to be cured. Simultaneously, since the photocured product is also high in strength on tearing apart, this reveals that the modeling material allows a photofabrication product to have sufficient strength.

Since the photofabrication model prepared with the present modeling material has high heat resistance and excellent mechanical properties, the present modeling is extremely useful as a modeling material for forming a photofabrication model in ink-jet stereo lithography.

## Claims

1. A modelling material suitable for forming a photofabrication model in ink-jet stereo lithography, comprising:
(i) a monofunctional ethylenically unsaturated monomer (A) free from a urethane group, a homopolymer of which has a glass transition temperature of ≥ 80°C;
(ii) a polyfunctional ethylenically unsaturated monomer (B) free from a urethane group, a homopolymer of which has a glass transition temperature of ≥ 200°C;
(iii) an ethylenically unsaturated monomer (C) which is a polyfunctional ethylenically unsaturated monomer (C1) having a urethane group in a concentration of 2.7-5.0 mmol/g; and
(iv) a photopolymerization initiator (D).

2. The modelling material of claim 1, wherein the monomer (A) has an alicyclic skeleton.

3. The modelling material of claim 1 or 2, wherein the monomer (B) has an alicyclic skeleton or an aromatic ring.

4. The modelling material of any of claims 1-3, which contains, on the basis of the weight of the modelling material, 50-90 wt.-% (A), 3-25 wt.-% (B), 5-35 wt.-% (C) and 0.1-10 wt.-% (D).

5. The modelling material of any of claims 1-4, wherein a photocured product of the modelling material has a glass transition temperature of 91-200°C.

6. The modelling material of any of claims 1-5, which further comprises at least one additive agent (E) selected from a polymerization inhibitor, a surfactant, a coloring agent, an oxidation inhibitor, a chain transfer agent, and a filler.

7. The modelling material of any of claims 1-6, which consists of the monomers (A)-(C), the photopolymerization initiator (D) and optionally at least one of an additive agent (E) selected from a polymerization inhibitor, a surfactant, a coloring agent, an oxidation inhibitor, a chain transfer agent, and a filler.

8. A two-pack type photocurable composition suitable for ink-jet stereo lithography comprising a combination of
- a modelling material which is suitable for forming a photofabrication model in ink-jet stereo lithography and comprises the modelling material of any of claims 1-7, and
- a supporting material supporting the shape of the photofabrication model on photofabrication.

9. The two-pack type photocurable composition of claim 9, wherein the modelling material consists of the modelling material of any of claims 1-7.

10. A method of producing a photofabrication model, comprising the step of photocuring the composition of claim 8 or 9 by ink-jet stereo lithography.

11. The method of claim 10, wherein the photofabrication model is produced with a three-dimensional modelling system.

12. The method of claim 11, wherein the three-dimensional modelling system comprises a personal computer and a three-dimensional modelling apparatus connected thereto.

13. A photofabrication model obtainable by the method of any of claims 10-12.

## Patentansprüche

1. Modelliermasse, das zur Bildung eines Photofabrikationsmodells in der Tintenstrahl-Stereolithographie geeignet ist, umfassend:
(i) ein monofunktionelles ethylenisch ungesättigtes Monomer (A), das frei von einer Urethangruppe ist, wobei ein Homopolymer hiervon eine Glasübergangstemperatur von ≥ 80°C aufweist;
(ii) ein polyfunktionelles ethylenisch ungesättigtes Monomer (B), das frei von einer Urethangruppe ist, wobei ein Homopolymer hiervon eine Glasübergangstemperatur von ≥ 200°C aufweist;
(iii) ein ethylenisch ungesättigtes Monomer (C), das ein polyfunktionelles ethylenisch ungesättigtes Monomer (C1) ist, aufweisend eine Urethangruppe in einer Konzentration von 2,7-5,0 mmol/g; und
(iv) einen Photopolymerisationsinitiator (D).

2. Modelliermasse gemäß Anspruch 1, wobei das Monomer (A) ein alizyclisches Gerüst aufweist.

3. Modelliermasse gemäß Anspruch 1 oder 2, wobei das Monomer (B) ein alizyklisches Gerüst oder einen aromatischen Ring aufweist.

4. Modelliermasse gemäß irgendeinem der Ansprüche 1 bis 3, die, bezogen auf das Gewicht der Modelliermasse, 50 bis 90 Gew.-% (A), 3 bis 25 Gew.-% (B), 5 bis 35 Gew.-% (C) und 0,1 bis 10 Gew.-% (D) enthält.

5. Modelliermasse gemäß irgendeinem der Ansprüche 1-4, wobei ein photogehärtetes Produkt der Modelliermasse eine Glasübergangstemperatur von 91-200°C aufweist.

6. Modelliermasse gemäß irgendeinem der Ansprüche 1-5, die ferner mindestens ein Additiv (E), ausgewählt aus einem Polymerisationsinhibitor, einem Tensid, einem Färbemittel, einem Oxidationsinhibitor, einem Kettenübertragungsmittel und einem Füllstoff, enthält.

7. Modelliermasse gemäß irgendeinem der Ansprüche 1-6, die aus den Monomeren (A)-(C), dem Photopolymerisationsinitiator (D) und gegebenenfalls mindestens einem Additiv (E), ausgewählt aus einem Polymerisationsinhibitor, einem Tensid, einem Färbemittel, einem Oxidationsinhibitor, einem Kettenübertragungsmittel und einem Füllstoff, besteht.

8. Photohärtbare Zusammensetzung vom Zweikomponententyp, die für die Tintenstrahl-Stereolithographie geeignet ist, umfassend eine Kombination von
- einer Modelliermasse, die zur Bildung eines Photofabrikationsmodells in der Tintenstrahl-Stereolithographie geeignet ist und die Modelliermasse gemäß irgendeinem der Ansprüche 1 bis 7 umfasst, und
- einem Trägermaterial, das die Form des Photofabrikationsmodells bei der Photofabrikation trägt.

9. Photohärtbare Zusammensetzung vom Zweikomponententyp gemäß Anspruch 9, wobei die Modelliermasse aus der Modelliermasse gemäß irgendeinem der Ansprüche 1-7 besteht.

10. Verfahren zur Herstellung eines Photofabrikationsmodells, umfassend den Schritt des Photohärtens der Zusammensetzung gemäß Anspruch 8 oder 9 durch Tintenstrahl-Stereolithographie.

11. Verfahren gemäß Anspruch 10, wobei das Fotofabrikationsmodell mit einem dreidimensionalen Modelliersystem hergestellt wird.

12. Verfahren gemäß Anspruch 11, wobei das dreidimensionale Modelliersystem einen Personalcomputer und eine daran angeschlossene dreidimensionale Modelliervorrichtung umfasst.

13. Fotofabrikationsmodell, erhältlich durch das Verfahren gemäß irgendeinem der Ansprüche 10-12.

## Revendications

1. Matériau de modelage adapté à la formation d'un modèle de photofabrication par stéréolithographie à jet d'encre, comprenant :
(i) un monomère monofonctionnel éthyléniquement insaturé (A) exempt d'un groupe uréthane, dont un homopolymère a une température de transition vitreuse ≥ 80°C;
(ii) un monomère polyfonctionnel éthyléniquement insaturé (B) exempt d'un groupe uréthane, dont un homopolymère a une température de transition vitreuse ≥ 200°C;
(iii) un monomère éthyléniquement insaturé (C) qui est un monomère polyfonctionnel éthyléniquement insaturé (C1) ayant un groupe uréthane en une concentration de 2,7-5,0 mmol/g ; et
(iv) un initiateur de photopolymérisation (D).

2. Matériau de modelage selon la revendication 1, dans lequel le monomère (A) a un squelette alicyclique.

3. Matériau de modelage selon la revendication 1 ou 2, dans lequel le monomère (B) a un squelette alicyclique ou un cycle aromatique.

4. Matériau de modelage selon l'une quelconque des revendications 1-3, qui contient, sur la base du poids du matériau de modelage, 50-90 % en poids de (A), 3-25 % en poids de (B), 5-35 % en poids de (C) et 0,1-10 % en poids de (D).

5. Matériau de modelage selon l'une quelconque des revendications 1-4, dans lequel un produit photodurci du matériau de modelage a une température de transition vitreuse de 91-200 °C.

6. Matériau de modelage selon l'une quelconque des revendications 1-5, qui comprend en outre au moins un additif (E) choisi parmi un inhibiteur de polymérisation, un tensioactif, un colorant, un inhibiteur d'oxydation, un agent de transfert de chaîne et une charge.

7. Matériau de modelage selon l'une quelconque des revendications 1-6, qui est constitué des monomères (A)-(C), de l'initiateur de photopolymérisation (D) et éventuellement d'au moins un d'un additif (E) choisi parmi un inhibiteur de polymérisation, un tensioactif, un colorant, un inhibiteur d'oxydation, un agent de transfert de chaîne et une charge.

8. Composition photodurcissable de type à deux composants adaptée à la stéréolithographie à jet d'encre comprenant une combinaison de
- un matériau de modelage qui est adapté pour former un modèle de photofabrication par stéréolithographie à jet d'encre et comprend le matériau de modelage selon l'une quelconque des revendications 1-7, et
- un matériau de support supportant la forme du modèle de photofabrication lors de la photofabrication.

9. Composition photodurcissable de type à deux composants selon la revendication 9, dans laquelle le matériau de modelage est constitué du matériau de modelage selon l'une quelconque des revendications 1-7.

10. Procédé de production d'un modèle de photofabrication, comprenant l'étape de photodurcissement de la composition de la revendication 8 ou 9 par stéréolithographie à jet d'encre.

11. Procédé selon la revendication 10, dans lequel le modèle de photofabrication est produit avec un système de modelage en trois dimensions.

12. Procédé selon la revendication 11, dans lequel le système de modelage en trois dimensions comprend un ordinateur personnel et un appareil de modelage en trois dimensions connecté à celui-ci.

13. Modèle de photofabrication pouvant être obtenu par le procédé selon l'une quelconque des revendications 10-12.
